# EUROPEAN PATENT SPECIFICATION

(11) **EP 3 993 586 B1**
(45) Date of publication and mention of the grant of the patent: **29.10.2025**
(21) Application number: 19935607.2
(22) Date of filing: 28.06.2019
(51) Int. Cl.: H05K 7/20, B60R 16/02, G06F 1/16, G06F 1/20

(54) **AVN DEVICE**
AVN-VORRICHTUNG
DISPOSITIF AVN

(43) Date of publication of application: 04.05.2022
(73) Proprietor: LG Electronics Inc., Seoul 07336 (KR)
(72) Inventor: YU, Jiwon, Seoul 06772 (KR); MOON, Kangseok, Seoul 06772 (KR); JUNG, Wonmoog, Seoul 06772 (KR); KIM, Joongnyon, Seoul 06772 (KR)
(74) Representative: Vossius & Partner Patentanwälte Rechtsanwälte mbB
(86) International application number: PCT/KR2019/007870
(87) International publication number: WO 2020/262739

(56) References cited:
- EP-A1- 1 672 642
- EP-A1- 2 261 812
- EP-A1- 3 461 249
- WO-A2-2009/025524
- FR-A1- 3 060 202
- JP-A- 2003 291 745
- JP-A- 2005 268 343
- JP-A- H11 251 775
- KR-A- 20170 135 853
- KR-Y1- 200 385 591

## Description

### [Technical Field]

The present disclosure relates to an audio video navigation (AVN) device, and more particularly to an AVN device configured in a manner that a replaceable portion including any element having a short replacement cycle is detachably coupled to a fixed portion, and the AVN device can be applied to a technical field capable of performing cooling through the fixed portion.

### [Background Art]

An audio video navigation (AVN) device is a vehicle-dedicated multimedia device which integrates an audio device, a video device, and a navigation device into one unit. The development of the AVN device provides a user with convenience of use in a process of manipulating various multimedia devices, and can efficiently use an internal space of the vehicle.

In recent years, an AVN device has been manufactured as a built-in AVN device that is built in and attached to the vehicle, and the built-in AVN device has been manufactured together with the vehicle and rapidly introduced to the market. The built-in AVN device has advantages in that the internal space of the vehicle can be more efficiently utilized, but has disadvantages in that the built-in AVN device can be manufactured differently depending on vehicle models, and replacement of the built-in AVN device is inconvenient. Considering that the lifespan of the AVN device is generally shorter than that of the vehicle, the necessity for the user to easily replace the AVN device with a desired device from among the latest devices is emerging.

In addition, the AVN device is a device that performs complex functions, and the replacement cycles of elements required to implement the functions may be different from each other. The replacement cycles of such elements may be determined differently according to the development speed of technology, or may also be determined differently according to durability. Since the AVN device is manufactured as an integrated unit, inefficiency may occur because the entire device should be replaced with a new device in a situation where there is a need to replace only some elements included in the device with other elements.

In addition, the AVN device is a small device that requires a large amount of computation in response to complex information, and a structure capable of effectively emitting internal heat is of importance to development of the AVN device.

EP 3 461 249 A1 discloses an electronic device including a plurality of circuit boards and a plurality of chassis enclosures. Each of the plurality of circuit boards is separately housed by a chassis enclosure. Each chassis enclosure includes a front housing and a back housing, the front housing and back housing configured to retain a circuit board, and at least one heat dissipation element. The plurality of chassis enclosures are mounted to provide an air gap for heat dissipation between each chassis enclosure. EP 1 672 642 A discloses an electronic built-in system for installation in a support structure mounted in a passenger compartment of a vehicle which comprises at least one electronic module. FR 3 060 202 A1 discloses on-board electronic multimedia control units in automobiles which generally comprise a metal casing provided with numerous electronic interface connectors.

### [Disclosure]

### [Technical Problem]

Accordingly, the present disclosure is directed to an AVN device that substantially obviates one or more problems due to limitations and disadvantages of the related art.

An object of the present disclosure is to provide an AVN device that is divided into a replaceable portion that is detachably coupled to the AVN device and a fixed portion that is fixed to a vehicle.

Another object of the present disclosure is to provide an AVN device provided with a replaceable portion that includes elements each having a short replacement cycle, thereby efficiently upgrading the AVN device.

Another object of the present disclosure is to provide an AVN device in which heat exchange between the replaceable portion and the fixed portion is facilitated, thereby increasing heat dissipation efficiency of the replaceable portion.

### [Technical Solutions]

In accordance with an aspect of the present disclosure, an AVN device includes a first housing including a first circuit board, a second housing including a second circuit board, and configured to be detachably coupled to the first housing, a conduction module provided between the first housing and the second housing in a situation where the second housing is coupled to the first housing, and a heat dissipation fan provided at one surface of the first housing, wherein the conduction module is configured to be compressed and thereby be in surface contact with both the first housing and the second housing at the same time when the second housing is coupled to the first housing; and a heat dissipation fan provided at one surface of the first housing to discharge heat generated in the first housing outside of the first housing.

The conduction module may include an adhesive sheet attached to one surface of the first housing or attached to one surface of the second housing, a thermally conductive sheet stacked on the other surface of the adhesive sheet, and a non-adhesive sheet stacked on the thermally conductive sheet and formed to have a non-adhesive exposed surface.

The conduction module may have a larger thickness than an assembly tolerance between the first housing and the second housing, and the conduction module is deformed according to the degree of compression of the first housing that is compressed when coupling to the second housing, so that the conduction module is in surface contact with the first housing and the second housing at the same time.

The second housing may be connected to a second electronic component that has a shorter replacement cycle than a first electronic component mounted in the first housing.

The first electronic component may be a fixed component that includes at least one of a vehicle interlocking component, a radio, and an audio.

The second electronic component may be a replaceable component that includes at least one of a CPU, a memory, and a communication device.

The first housing may include a plurality of metal fins formed to protrude from an inner surface facing or opposite to an outer surface formed to contact the second housing.

The first housing may include a coupling portion configured to form an accommodation space to which the second housing is coupled.

The second housing may include a coupling surface formed to contact the coupling portion; and an exposed surface formed to be exposed outside.

The conduction module maybe provided at the coupling surface of the second housing.

The first housing may further include the conduction module provided at one surface of the first housing; and a metal sheet formed to cover the conduction module.

The second housing may include a metal material that has a higher thermal conductivity than a metal material constituting the first housing.

### [Advantageous Effects]

As is apparent from the above description, the AVN device according to the embodiments of the present disclosure can have the following effects.

The AVN device according to the embodiments of the present disclosure may be divided into a replaceable portion that is detachably coupled to the AVN device and a fixed portion that is fixed to a vehicle.

The AVN device according to the embodiments of the present disclosure may be provided with a replaceable portion that includes elements each having a short replacement cycle, thereby efficiently upgrading the AVN device.

The AVN device according to the embodiments of the present disclosure is configured in a manner that heat exchange between the replaceable portion and the fixed portion is facilitated, thereby increasing heat dissipation efficiency of the replaceable portion.

Further scope of applicability of the present disclosure will become apparent from the detailed description given hereinafter. However, it should be understood that the detailed description and specific examples, while indicating preferred embodiments of the invention, are given by illustration only, since various changes and modifications within the spirit and scope of the invention will become apparent to those skilled in the art from this detailed description.

### [Description of Drawings]

FIG. 1 is a block diagram illustrating an AVN device according to the present disclosure.
FIG. 2 is a conceptual diagram illustrating an AVN device according to an embodiment of the present disclosure.
FIG. 3 is a diagram illustrating movement of heat generated inside a second housing of the AVN device according to an embodiment of the present disclosure.
FIG. 4 is a diagram illustrating a coupling surface between a first housing and the second housing of the AVN device according to an embodiment of the present disclosure.
FIG. 5 is a conceptual diagram illustrating an AVN device according to another embodiment of the present disclosure.

### [Best Mode]

Description will now be given in detail according to exemplary embodiments disclosed herein, with reference to the accompanying drawings. For the sake of brief description with reference to the drawings, the same or equivalent components may be provided with the same reference numbers, and description thereof will not be repeated. In general, a suffix such as "module" and "unit" may be used to refer to elements or components. Use of such a suffix herein is merely intended to facilitate description of the specification, and the suffix itself is not intended to give any special meaning or function. In the present disclosure, that which is well-known to one of ordinary skill in the relevant art has generally been omitted for the sake of brevity. The accompanying drawings are used to help easily understand various technical features and it should be understood that the embodiments presented herein are not limited by the accompanying drawings. As such, the present disclosure should be construed to extend to any alterations, equivalents and substitutes in addition to those which are particularly set out in the accompanying drawings.

It will be understood that although the terms first, second, etc. may be used herein to describe various elements, these elements should not be limited by these terms. These terms are generally only used to distinguish one element from another.

It will be understood that when an element is referred to as being "connected with" another element, the element can be directly connected with the other element or intervening elements may also be present. In contrast, when an element is referred to as being "directly connected with" another element, there are no intervening elements present.

A singular representation may include a plural representation unless it represents a definitely different meaning from the context.

Terms such as "include" or "has" are used herein and should be understood that they are intended to indicate an existence of several components, functions or steps, disclosed in the specification, and it is also understood that greater or fewer components, functions, or steps may likewise be utilized.

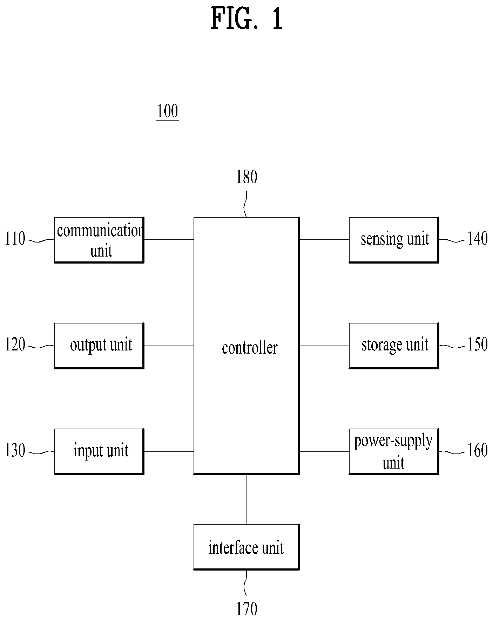

FIG. 1 is a block diagram illustrating an AVN device 100 according to the present disclosure.

Referring to FIG. 1, the AVN device 100 may include a communication unit 110, an output unit 120, an input unit 130, a sensing unit 140, a storage unit 150, a power-supply unit 160, an interface unit 170, and a controller 180. The constituent elements shown in FIG. 1 are not always required to implement the AVN device 100, such that it should be noted that the AVN device 100 according to the present disclosure may include more or fewer components than the elements listed above.

More specifically, the communication unit 110 may include at least one module for implementing any one of communication between the AVN device 100 and a wireless communication system, communication between the AVN device 100 and another device, and communication between the AVN device 100 and an external server. In addition, the communication unit 110 may include at least one module for connecting the AVN device 100 to at least one network.

The communication unit 110 may include at least one of a broadcast reception module, a mobile communication module, a wireless Internet module, a short-range communication module, and a location information module. The antenna may be built in the AVN device 100, or may be disposed at the outer surface of a vehicle.

The output unit 120 may generate output signals related to visual, auditory, and tactile sensation, or the like. The output unit 120 may include at least one of a display module and an audio output module. The display module may construct a mutual layer structure along with a touch sensor, or may be formed integrally with the touch sensor, such that the display module can be implemented as a touchscreen. The touchscreen may serve as an input unit 130 that provides an input interface to be used between the AVN device 100 and the user, and at the same time may provide an output interface to be used between the AVN device 100 and the user.

The input unit 130 may include a camera (or an image input unit) for receiving image signals, a microphone (or an audio input unit) for receiving audio signals, and a user input unit (e.g., a touch key, a mechanical key, etc.) for receiving information from the user. Voice data or image data collected by the input unit 130 may be analyzed so that the analyzed result can be processed as a control command of the user as necessary.

The input unit 130 may be configured to input image information (or image signals), audio information (or audio signals), data, or information input by the user, and may include at least one camera for inputting image information. The camera may be a part of the AVN device 100, or may be a structure including the AVN device 100. That is, the camera and the AVN device 100 may include at least some common features or configurations. The camera may process image frames such as still images or moving images obtained by the image sensor in a photographing mode. The processed image frame may be displayed on the display unit or stored in the storage unit 150. The camera provided in the AVN device 100 may be arranged to form a matrix structure inside the vehicle. Through the camera forming the matrix structure, the plurality of image information having various angles or focuses may be input to the AVN device 100. In addition, the camera may be a stereo vision camera or a TOF camera to implement 3D images.

The sensing unit 140 may include one or more sensors configured to sense internal information of the AVN device 100, peripheral environmental information of the AVN device, user information, and the like. For example, the sensing unit 140 may include at least one of a proximity sensor, an illumination sensor, a touch sensor, an acceleration sensor, a magnetic sensor, a gravity sensor (G-sensor), a gyroscope sensor, a motion sensor, an RGB sensor, an infrared (IR) sensor, a fingerprint scan sensor, an ultrasonic sensor, an optical sensor, an environment sensor (for example, a barometer, a hygrometer, a thermometer, a radioactivity detection sensor, a thermal sensor, and a gas sensor, etc.), and a chemical sensor (for example, an electronic nose, a healthcare sensor, a biometric sensor, and the like). On the other hand, the AVN device 100 disclosed in the present disclosure may combine various kinds of information sensed by at least two of the above-described sensors, and may use the combined information. Representative sensors among various sensors that can be included in the sensing unit 140 will be described in more detail.

The proximity sensor detects an object approaching a designated detection surface or whether or not an object is present around the proximity sensor using electromagnetic force or infrared light without mechanical contact. The proximity sensor may be disposed in the inner area of the AVN device 100 surrounded by a touchscreen, which will be described later, or disposed around the touchscreen.

For example, the proximity sensor may be a transmissive photoelectric sensor, a direct reflective photoelectric sensor, a mirror reflective photoelectric sensor, a highfrequency oscillating proximity sensor, a capacitive proximity sensor, a magnetic proximity sensor, an infrared proximity sensor, etc. If the touchscreen is a capacitive touchscreen, the proximity sensor may be configured to detect proximity of an object having conductivity through change in an electric field according to proximity of the object. In this case, the touchscreen (or a touch sensor) itself may be regarded as a proximity sensor.

On the other hand, for convenience of description, an action in which an object is brought close to the touchscreen without contact and thus it is recognized that the object is located on the touchscreen is referred to as "proximity touch", and an action in which an object actually contacts the touchscreen is referred to as "contact touch". A proximity touch position of an object on the touchscreen means a position of the touchscreen vertically corresponding to the object when the object is in the proximity touch state on the touchscreen. The proximity sensor may sense proximity touch and a proximity touch pattern (for example, a proximity touch distance, a proximity touch direction, a proximity touch speed, a proximity touch time, a proximity touch position, a proximity touch moving state, etc.). The controller 180 may process data (or information) corresponding to the proximity touch operation and the proximity touch pattern sensed by the proximity sensor and output visual information corresponding to the processed data on the touchscreen. Further, the controller 180 may control the AVN device 100 so as to process different operations or data (or information) according to whether or not touch of the object at the same point of the touchscreen is proximity touch or contact touch.

The touch sensor senses touch (or touch input) applied to the touchscreen (or the display unit) using at least one of various touch methods, i.e., a resistive method, a capacitive method, an infrared method, an ultrasonic method, a magnetic field method, etc.

For example, the touch sensor may be configured to convert change in pressure applied to a specific region of the touchscreen or capacitance generated from a specific region of the touchscreen into an electrical input signal. The touch sensor may be configured to detect a touch position of an object on the touchscreen, a touch area of the object, a touch pressure of the object, a capacitance of the object, etc. Here, the object is an article touching the touchscreen and, for example, may be a finger, a touch pen or stylus, or a pointer.

In this way, when touch inputs are sensed by the touch sensors, corresponding signals may be transmitted to a touch controller. The touch controller may process the received signals, and then transmit corresponding data to the controller 180. Accordingly, the controller 180 can sense which region of the display unit 151 has been touched. Here, the touch controller may be a component separate from the controller 180 or the controller 180 itself.

The controller 180 may perform different control according to kinds of objects touching the touchscreen (or a touch key provided in other regions than the touchscreen), or perform equal control regardless of kinds of objects touching the touchscreen. Whether or not different control is performed or equal control is performed according to kinds of objects may be determined according to the current operating state of the AVN device 100 or an application program which is being executed.

The above-described touch sensor or proximity sensor may be independently used or be combined to sense various types of touch, such as short (or tap) touch, long touch, multi-touch, drag touch, flick touch, pinch-in touch, pinch-out touch, swipe touch, hovering touch, etc., on the touchscreen.

The storage unit 150 may store data for supporting various functions of the mobile terminal 100. The storage unit 150 may store a plurality of application programs (or applications) executed in the AVN device 100, data for operations of the AVN device 100, instructions, and the like. At least some of those application programs may be downloaded from an external server via wireless communication. Some others of those application programs may be installed within the AVN device 100 at the time of being shipped for basic functions of the AVN device 100 (for example, a navigation function, artificial intelligence (AI) function, a broadcast reception function, and a broadcast output function, etc.). Further, the application programs may be stored in the storage unit 150, installed in the AVN device 100, and executed by the controller 180 to perform an operation (or a function) of the AVN device 100.

The power-supply unit 160 may receive external power or internal power under control of the controller 180, such that the power-supply unit 160 may supply the received power to the constituent components included in the AVN device 100. The power-supply unit 160 may include a battery included in the vehicle. The battery may be implemented as an embedded battery or a replaceable battery.

The interface unit 170 serves as an interface with various kinds of external devices connected to the AVN device 100. The interface unit 170 may include at least one of wired/wireless headset ports, an external charger port, wired/wireless data ports, a memory card port, and a port for connection with a device provided with an identification module. In response to connection of an external device to the interface unit 150, the AVN device 100 may perform proper control regarding the connected external device.

The interface unit 170 may include a user interface (UI) for interacting with the user. Since the present disclosure provides a user interface (UI) based on voice or vision, it is possible to perform complex functions of the AVN device 100 without action of the user who directly touches the AVN device 100.

The user interface (UI) based on touch input may be considered dangerous in a vehicle driving process in which the user should interact with the AVN device 100 while looking at the AVN device 100. In contrast, the user interface (UI) based on voice or vision can enable the user to interact with the AVN device 100 without looking at the AVN device 100, so that this voice or vision-based UI may be considered more appropriate for the AVN device 100.

However, the voice-based UI may have limitations depending on the surrounding environments. For example, the voice-based UI may have difficulty in distinguishing voice of the user who drives the vehicle, if there is a passenger in the vehicle or the indoor space of the vehicle is in a noisy state due to noise received from outside through an opened window. In addition, it is inconvenient for the user to interact with the AVN device through his or her voice, when a passenger in the vehicle is on the phone or is resting.

Therefore, the vision-based user interface (UI) can provide convenience for the user to interact with the AVN device in the above limited situation. Accordingly, technology for enabling the AVN device to interact with the user through the vision-based UI has recently been actively researched.

In addition to the operations related to the application program installed in the AVN device 100, the controller 180 can control overall operation of the AVN device 100, thereby performing vehicle control. The controller 180 may process input/output (I/O) signals, data, information, etc. through the above-described components, or may provide the application program stored in the storage unit 150, so that the controller 180 can provide the user with appropriate information or functions or can process necessary operations.

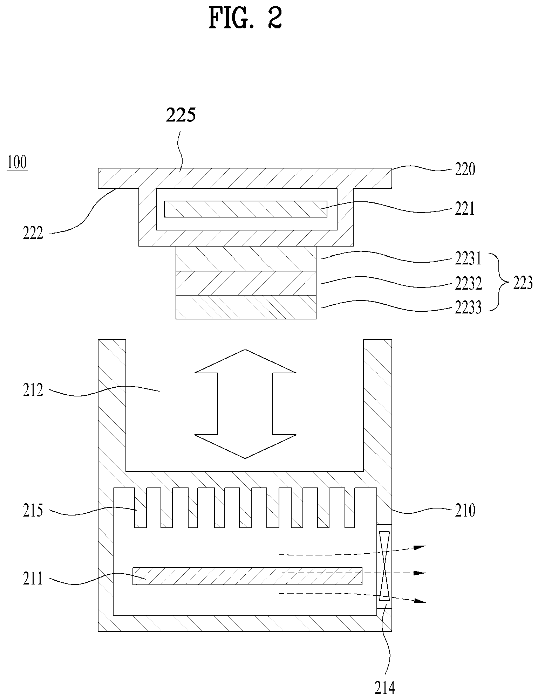

FIG. 2 is a conceptual diagram illustrating the AVN device 100 according to an embodiment of the present disclosure.

The AVN device 100 may include a first housing 210 and a second housing 220 detachably coupled to the first housing 210. The first housing 210 may be a fixed portion fixed to the vehicle, and the second housing 220 may be a replaceable (or changeable) unit. Specifically, the first housing may be directly embedded in the vehicle and connected thereto.

The first housing 210 may include a first circuit board 211 in an internal mounting space, and the second housing 220 may include a second circuit board 221 in an internal mounting space. The first circuit board 211 may be connected to a first electronic component provided in the first housing 210, and the second circuit board 221 may be connected to a second electronic component provided in the second housing 220. In some cases, the AVN device 100 according to the present disclosure may include a single circuit board in the first housing 210 or the second housing 220, and the single circuit board may be coupled to the first electronic component provided in the first housing 210 and the second electronic component provided in the second housing 220.

The second electronic component provided in the second housing 220 may have a shorter replacement cycle than the first electronic component provided in the first housing 210. The replacement cycle may be determined differently depending on a period in which upgraded electronic components are introduced to the market due to rapid development of technology, or may be determined differently according to durability or function degradation rate.

For example, the first electronic component may be a fixed component that includes at least one of audio, vehicle interlocking components, and radio. Here, the fixed component may be a component that need not be replaced or has a very long replacement cycle. The second electronic component may be a replaceable component that includes at least one of a CPU, a memory, and a communication device. Here, the interlocking component may be a component having a replacement cycle shorter than that of the fixed component.

The first circuit board 211 and the second circuit board 221 may be configured to conduct electricity through terminals thereof when the first housing 210 and the second housing 220 are coupled to each other. When the first circuit board 211 and the second circuit board 221 are electrically connected, the entire AVN device 100 can be controlled through a CPU (i.e., controller) provided in the second circuit board 221.

In the present disclosure, the second housing 220 serving as a replaceable portion is detachably coupled to the first housing 210, electronic components (hereinafter referred to as long-term electronic components) each having a long replacement cycle or permanent electronic components that need not be replaced with new ones are provided in the first housing 210, and other electronic components (hereinafter referred to as short-term electronic components) each having a short replacement cycle are provided in the second housing 220, so that the AVN device 100 can be upgraded by replacing only the second housing 220 with a new one according to a replacement cycle of the second housing 220. In this case, in order to replace the short-term electronic component having a short replacement cycle with a new one, it is not necessary for the entire AVN device 100 to be replaced with a new AVN device, thereby preventing waste of resources. In addition, the second housing 220 is detachably provided in the AVN device, thereby providing the user with greater convenience in replacement. In recent times, as the demand for the AVN device 100 manufactured as a built-in type is rapidly increasing, the AVN device 100 can be manufactured in different shapes according to vehicle models. Accordingly, according to the present disclosure, the first housing 220 is manufactured as a built-in type in response to vehicle models, but the second housing 220 is manufactured according to a unified standard regardless of vehicle model types, so that waste of resources can be prevented.

The first housing 210 may include a coupling portion 212 that forms an accommodation space to which the second housing 220 is coupled. The second housing 220 may include a coupling surface 222 that is in contact with the coupling portion 212 when connected to the coupling portion 212, and an exposed surface 225 exposed outside when connected to the coupling portion 212. The second housing 220 may emit heat generated therein to the outside through the exposed surface 225. Specifically, the second housing 220 may discharge heat generated in the second circuit board 221 to the outside using convection and radiation through the exposed surface 225. The second housing 220 may be formed of a metal material to easily discharge internal heat through the exposed surface 225. In addition, heat generated in the second housing 220 may be conducted to the first housing 210 and dissipated to the outside. In order to easily conduct heat generated in the second housing 220 to the first housing 210, the first housing 210 may be formed of a metal material. Specifically, the coupling portion 212 of the first housing 210 may be made of a metal material, and the remaining parts other than the coupling portion 212 may be made of a plastic material.

The AVN device 100 according to the present disclosure may include a conduction module 223 provided at one surface of the first housing 210 or at one surface of the second housing 220. Specifically, the AVN device 100 according to the present disclosure may include a conduction module 223 installed on the coupling surface 222 of the second housing 220.

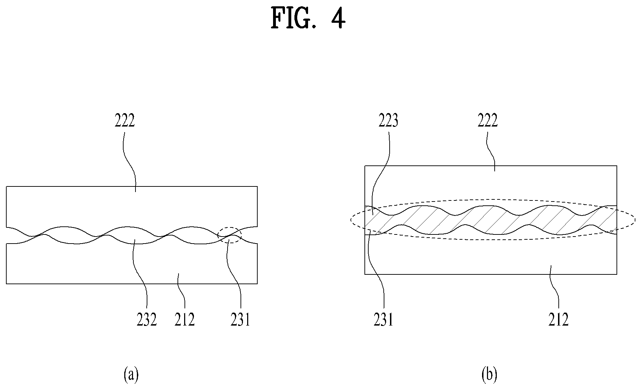

When the second housing 220 is coupled to the first housing 210, the conduction module 223 may be provided between the first housing 210 and the second housing 220 to function as a passage for heat exchange. Specifically, the conduction module 223 may include an adhesive sheet 2231 attached to either one surface of the first housing 210 or one surface of the second housing 220, a thermally conductive sheet 2232 stacked on the adhesive sheet 2231, and a non-adhesive sheet 2233 stacked on the thermally conductive sheet 2232. The adhesive sheet 2231 may be a double-sided adhesive sheet attached to one surface of the first housing 210 or attached to one surface of the second housing 220. The thermally conductive sheet 2232 may be a sheet made of a material having high thermal conductivity. The non-adhesive sheet 2233 may be stacked on the thermally conductive sheet 2232, so that one surface of the non-adhesive sheet 223 adheres to the thermally conductive sheet 2232, and the other surface the non-adhesive sheet 223 does not have adhesive properties. A detailed description thereof will be given with reference to FIG. 4.

The first housing 210 may include a fan 214 for discharging heat generated therein to the outside. Since the first housing 210 serves as a fixed portion, the first housing 210 may have a larger size and a larger clearance than the second housing 220. Thus, the fan 214 is preferably included in the first housing 210 rather than in the second housing 220. In addition, the fan 214 is preferably provided in the first housing 210 rather than the second housing 220 because the fan 214 is considered to be a permanent electronic component having a long replacement cycle, but is not limited thereto, If necessary, the fan 214 may be provided in the second housing 220. In this case, the fan 214 provided in the first housing 210 may have superior performance to the other fan provided in the second housing 220.

In addition, the first housing 210 may include a plurality of metal fins 214 protruding from the inner surface thereof. The metal fins 210 may be configured to widen the inner surface of the first housing 210 so that heat transferred from the second housing 220 may be dissipated to the inner space of the first housing 210 and dissipated to the outside through the fan 214.

A process in which heat generated in the second housing 220 is dissipated to the outside will hereinafter be described in detail.

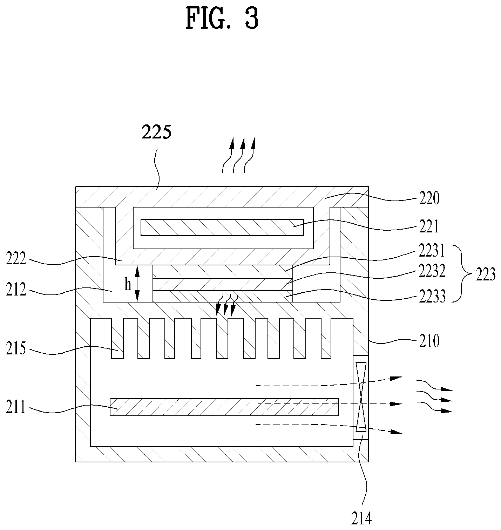

FIG. 3 is a diagram illustrating movement of heat generated inside the second housing 220 of the AVN device 100 according to an embodiment of the present disclosure.

The second circuit board 221 provided in the second housing 220 is used to control the AVN device 100 and to perform calculation of the AVN device 100, so that the second circuit board 221 may have a greater amount of heat generated therein as compared to the first circuit board 211. Therefore, the structure designed to emit heat generated in the second housing 220 to the outside may be considered more important.

Heat generated in the second housing 220 may be emitted to the outside through convection and radiation on the exposed surface 225. The second housing 220 may constitute the exposed surface 225 using a high-conductivity metal material so as to facilitate convection and radiation on the exposed surface 225.

In the present disclosure, the second housing 220 may serve as a replaceable portion, and may be detachably coupled to the first housing 210 acting as a fixed portion. When the second housing 220 is coupled to the first housing 210, heat generated in the second housing 220 may be conducted to the first housing 210 and dissipated to the outside.

Specifically, heat conducted from the second housing 220 to the first housing 210 may be dissipated to the outside through convection and radiation at the surface of the second housing 210. At this time, the fan 214 provided in the first housing 210 may perform a function of cooling the first housing 210. That is, heat generated in the second housing 220 may be dissipated to the outside through the fan 214 of the first housing 210 to which the second housing 220 is coupled.

In order to easily transfer heat generated in the second housing 220 to the first housing 210, the AVN device 100 according to the present disclosure may include a conduction module 223 and a metal fin 215.

The conduction module 223 may fix the thermally conductive sheet 2232 through the adhesive sheet 2231, and may not prevent the second housing 220 from being attached to and detached from the first housing 210 using the non-adhesive sheet 2233.

The conduction module 223 is compressed when the second housing 220 is coupled to the first housing 210, so that the conduction module 23 can be in surface contact with both the first housing 210 and the second housing 220 at the same time. The conduction module 223 may easily conduct heat generated in the second housing to the first housing 210 through surface contact. A detailed description thereof will be given with reference to FIG. 4.

The conduction module 223 may have a larger thickness than an assembly tolerance (h) between the first housing 210 and the second housing 220. In addition, the thickness of the conduction module 223 may be equal to or less than a thickness that does not interfere with coupling between the first housing 210 and the second housing 220. That is, the conduction module 223 has a thickness that does not interfere with coupling between the first housing 210 and the second housing 220, and at the same time is compressed, so that the conduction module 223 may have a thickness that enables the conduction module 223 to be simultaneously in surface contact with both the first housing 210 and the second housing.

In the present disclosure, the plurality of metal fins 215 may be provided at the inner surface of the first housing 210, so that heat generated in the second housing 220 can be easily conducted to the first housing 210. Specifically, the metal fins 215 provided at the inner surface of the first housing 210 may enlarge a contact area where heat conducted to the first housing 210 is dissipated to the inside of the first housing 210 to perform cooling of the first housing 210, resulting in increased efficiency for enabling heat generated in the second housing 220 to be conducted to the first housing 210.

To this end, the metal fins 215 may be provided at one surface, which faces or is opposite to the outer surface of the first housing 210 contacting the second housing 220, from among the inner surface of the first housing 210. That is, heat generated by the second housing 220 may be convectively radiated to the inside of the first housing 210 along the metal fins 215 of the first housing 210, and may be dissipated to the outside through the fan 214.

FIG. 4 is a diagram illustrating a coupling surface between the first housing 210 and the second housing 220 for use in the AVN device 100. For better understanding of the present disclosure, the following description of FIG. 4 will be given by further referring to FIG. 3 as necessary.

In the present disclosure, the first housing 210 and the second housing 220 may be detachably coupled to each other, and may not be integrated into one unit. Therefore, although the first housing 210 and the second housing 220 are coupled to each other, a gap (or a void) 232 may be formed around the coupling portion between the first housing 210 and the second housing 220.

Specifically, FIG. 4(a) is a diagram illustrating an example in which the gap 232 occurs in the coupling portion between the first housing 210 and the second housing 220 in a situation where the conduction module 223 is not included in the AVN device. When the second housing 220 is coupled to the first housing 210, the coupling portion 212 of the first housing 210 and the coupling surface 222 of the second housing 220 are in point contact with each other without being completely in close contact with each other, resulting in formation of the gap 232. The generated gap 232 may decrease conduction of heat from the second housing 220 to the first housing 210.

To address this problem, the AVN device according to the present disclosure may allow the conduction module 223 to be disposed between the first housing 210 and the second housing 220. Specifically, FIG. 4(b) is a diagram illustrating an example in which the conduction module 223 is compressed and is thus in surface contact (233) with both the coupling portion 212 of the first housing 210 and the coupling portion 222 of the second housing 220 at the same time.

That is, the present disclosure is characterized in that thermal conductivity reduction caused by detachable coupling between the first housing 210 and the second housing 220 can be compensated through the conduction module 223.

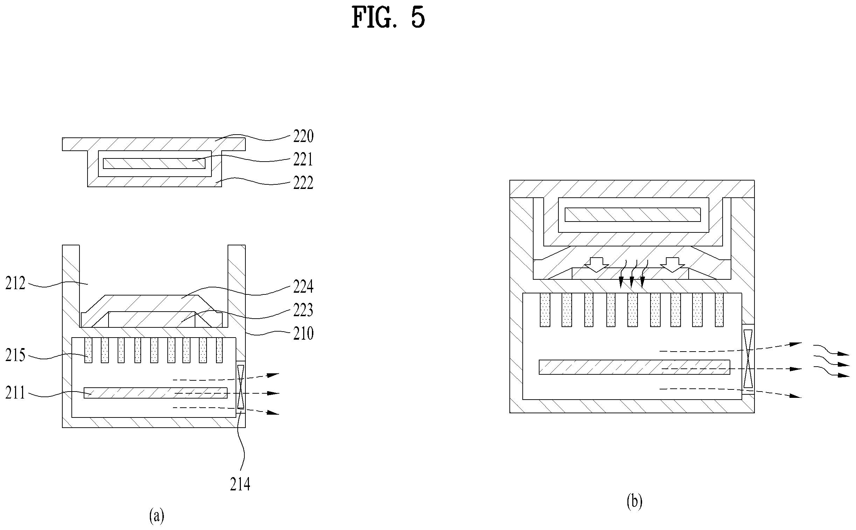

FIG. 5 is a conceptual diagram illustrating an AVN device 100 according to another embodiment of the present disclosure. For convenience of description, the AVN device 100 shown in FIG. 5 will hereinafter be described centering upon characteristics different from those of FIGS. 2 and 3.

In the present disclosure, the conduction module 223 is provided in the second housing 220 acting as the replaceable portion, so that the conduction module 223 can also be replaced simultaneously with replacement of the second housing 220.

The conduction module 223 is compressed when the second housing 220 is coupled to the first housing 210. If the conduction module 223 is used for a long time, the conduction module 223 may be deformed, so that the contact area between the second housing 220 and the first housing 210 may be reduced in size. Therefore, it may be preferable that the conduction module 223 is replaced together with the second housing 220, rather than being used in a fixed manner within the first housing 210.

However, when the degree of deformation of the conduction module 223 is not large, the conduction module 223 may be provided in the first housing 210 so as to be used in a fixed manner. In this case, when the conduction module 223 is directly exposed to the outside, a foreign material is caught in a gap between the first housing 210 and the second housing 220, so that the contact area between the first housing 210 and the second housing 220 is reduced in size. As a result, thermal conductivity for enabling heat generated in the second housing 220 to be transferred to the first housing 220 may decrease. Therefore, the present disclosure may allow the conduction module 223 to be disposed at the outer surface of the first housing 210, and may further include a metal sheet 224 formed to cover the conduction module 223.

FIG. 5(a) is a diagram illustrating an example in which the conduction module 23 is included in the coupling portion 212 of the first housing 210, and the metal sheet 224 is formed to cover the conduction module 223. FIG. 5(b) is a diagram illustrating that the second housing 220 is coupled to the first housing 210 so that the conduction module 223 is compressed.

As can be seen from FIG. 5(b), the conduction module 223 is compressed so that the compressed conduction module 223 can be simultaneously in surface contact with the coupling portion 212 of the first housing 210 and the metal sheet 224. However, the coupling surface 222 between the metal sheet 224 and the second housing 220 may be in point contact as shown in FIG. 4, resulting in formation of a gap. However, contact force caused by external force generated by compression of the conduction module 223 occurs in the second coupling surface 222 between the metal sheet 224 and the second housing, resulting in formation of a smaller gap as compared to FIG. 4. Accordingly, heat generated inside the second housing 220 may be conducted to the first housing 210, so that the conducted heat can be easily dissipated to the outside.

It will be apparent to those skilled in the art that various modifications and variations can be made without departing from the scope of the invention defined in the appended claims.

## Claims

1. An Audio Video Navigation (AVN) device comprising:
a first housing (210) including a first circuit board (211);
a second housing (220) including a second circuit board (221), and configured to be detachably coupled to the first housing (210);
a conduction module (223) provided between the first housing (210) and the second housing (220) in a situation where the second housing (220) is coupled to the first housing (210),
**characterized in that** the conduction module (223) is configured to be compressed and thereby be in surface contact with both the first housing (210) and the second housing (220) at the same time when the second housing (220) is coupled to the first housing (210); and
the AVN device further comprises a heat dissipation fan (214) provided at one surface of the first housing (210) to discharge heat generated in the first housing (210) outside of the first housing (210).

2. The AVN device according to claim 1, wherein the conduction module (223) includes:
an adhesive sheet (2231), one surface of which is attached to one surface of the first housing (210) or attached to one surface of the second housing (220);
a thermally conductive sheet (2232) stacked on the other surface of the adhesive sheet (2231); and
a non-adhesive sheet (2233) stacked on the thermally conductive sheet (2232) and formed to have a non-adhesive exposed surface.

3. The AVN device according to claim 1, wherein:
the conduction module (223) has a larger thickness than an assembly tolerance between the first housing (210) and the second housing (220); and
the conduction module (223) is configured to be deformed according to a degree of compression of the first housing (210) when being coupling to the second housing (220).

4. The AVN device according to claim 1, further comprising:
a first electronic component provided in the first housing (210) and connected to the first circuit board (211); and
a second electronic component provided in the second housing (220), connected to the second circuit board (221), and having a shorter replacement cycle than the first electronic component mounted in the first housing (210).

5. The AVN device according to claim 4, wherein:
the first electronic component is a fixed component that includes at least one of a vehicle-interlocked component, a radio, and an audio; and
the second electronic component is a replaceable component that includes at least one of a CPU, a memory, and a communication device.

6. The AVN device according to claim 1, wherein the first housing (210) includes:
a plurality of metal fins (215) protruding from an inner surface of the first housing (210) facing or being opposite to an outer surface of the first housing (210) contacting the second housing (220).

7. The AVN device according to claim 1, wherein the first housing (210) includes:
a coupling portion (212) configured to form an accommodation space to which the second housing (220) is coupled.

8. The AVN device according to claim 7, wherein the second housing (220) includes:
a coupling surface (222) configured to contact the coupling portion (212); and
an exposed surface (225) configured to be exposed outside.

9. The AVN device according to claim 8, wherein:
the conduction module (223) is provided at the coupling surface (222) of the second housing (220).

10. The AVN device according to claim 1, wherein the conduction module (223) is provided at one surface of the first housing (210); and the first housing (210) comprises a metal sheet (224) configured to cover the conduction module (223).

11. The AVN device according to claim 1, wherein:
the second housing (220) includes a metal material that has a higher thermal conductivity than a metal material constituting the first housing (210).

12. The AVN device according to claim 1, wherein the first housing (210) includes a plurality of metal fins (214) protruding from an inner surface of the first housing (210),
wherein heat transferred from the second housing (220) is dissipated to an inner space of the first housing (210) and then dissipated to the outside of the first housing (210) through the fan (214).

13. The AVN device according to claim 1, further comprising terminals, through which the first circuit board (211) and the second circuit board (221) are configured to conduct electricity when the first housing (210) and the second housing (220) are coupled to each other.

## Patentansprüche

1. Audio-Video-Navigationsvorrichtung (AVN-Vorrichtung), aufweisend:
ein erstes Gehäuse (210) einschließlich einer ersten Leiterplatte (211);
ein zweites Gehäuse (220) einschließlich einer zweiten Leiterplatte (221) und konfiguriert, um mit dem ersten Gehäuse (210) lösbar gekoppelt zu werden;
ein Leitungsmodul (223), das zwischen dem ersten Gehäuse (210) und dem zweiten Gehäuse (220) in einer Situation, in der das zweite Gehäuse (220) mit dem ersten Gehäuse (210) gekoppelt ist, bereitgestellt ist,
**dadurch gekennzeichnet, dass** das Leitungsmodul (223) konfiguriert ist, um komprimiert zu werden und dadurch gleichzeitig sowohl mit dem ersten Gehäuse (210) als auch dem zweiten Gehäuse (220) in Oberflächenkontakt zu kommen, wenn das zweite Gehäuse (220) mit dem ersten Gehäuse (210) gekoppelt ist; und
die AVN-Vorrichtung ferner einen Wärmeableitungslüfter (214), der an einer Oberfläche des ersten Gehäuses (210) bereitgestellt ist, um Wärme, die in dem ersten Gehäuse (210) erzeugt wird, nach außerhalb des ersten Gehäuses (210) abzugeben, aufweist.

2. AVN-Vorrichtung nach Anspruch 1, wobei das Leitungsmodul (223) einschließt:
eine Klebefolie (2231), deren eine Oberfläche an einer Oberfläche des ersten Gehäuses (210) befestigt ist oder an einer Oberfläche des zweiten Gehäuses (220) befestigt ist;
eine wärmeleitende Folie (2232), die auf der anderen Oberfläche der Klebefolie (2231) gestapelt ist; und
eine nicht klebende Folie (2233), die auf der wärmeleitenden Folie (2232) gestapelt und geformt ist, um eine nicht klebende freiliegende Oberfläche zu haben.

3. AVN-Vorrichtung nach Anspruch 1, wobei:
das Leitungsmodul (223) eine größere Dicke als eine Montagetoleranz zwischen dem ersten Gehäuse (210) und dem zweiten Gehäuse (220) aufweist; und
das Leitungsmodul (223) konfiguriert ist, um gemäß einem Kompressionsgrad des ersten Gehäuses (210) verformt zu werden, wenn es mit dem zweiten Gehäuse (220) gekoppelt wird.

4. AVN-Vorrichtung nach Anspruch 1, ferner aufweisend:
eine erste elektronische Komponente, die in dem ersten Gehäuse (210) bereitgestellt und mit der ersten Leiterplatte (211) verbunden ist; und
eine zweite elektronische Komponente, die in dem zweiten Gehäuse (220) bereitgestellt ist, mit der zweiten Leiterplatte (221) verbunden ist und einen kürzeren Austauschzyklus als die erste elektronische Komponente, die in dem ersten Gehäuse (210) angebracht ist, hat.

5. AVN-Vorrichtung nach Anspruch 4, wobei:
die erste elektronische Komponente eine feste Komponente ist, die mindestens eines von einer fahrzeugverblockten Komponente, einem Radio und einem Audio einschließt; und
die zweite elektronische Komponente eine austauschbare Komponente ist, die mindestens eines von einer CPU, einem Speicher und einer Kommunikationsvorrichtung einschließt.

6. AVN-Vorrichtung nach Anspruch 1, wobei das erste Gehäuse (210) einschließt:
eine Vielzahl von Metallrippen (215), die aus einer Innenoberfläche des ersten Gehäuses (210) hervorstehen, wobei sie einer Außenoberfläche des ersten Gehäuses (210), die das zweite Gehäuse (220) berührt, zugewandt sind oder dieser gegenüberliegen.

7. AVN-Vorrichtung nach Anspruch 1, wobei das erste Gehäuse (210) einschließt:
einen Kopplungsabschnitt (212), der konfiguriert ist, um einen Aufnahmeraum, an den das zweite Gehäuse (220) gekoppelt ist, auszubilden.

8. AVN-Vorrichtung nach Anspruch 7, wobei das zweite Gehäuse (220) einschließt:
eine Kopplungsoberfläche (222), die konfiguriert ist, um den Kopplungsabschnitt (212) zu berühren; und
eine freiliegende Oberfläche (225), die konfiguriert ist, um nach außerhalb freizuliegen.

9. AVN-Vorrichtung nach Anspruch 8, wobei:
das Leitungsmodul (223) an der Kopplungsoberfläche (222) des zweiten Gehäuses (220) bereitgestellt ist.

10. AVN-Vorrichtung nach Anspruch 1, wobei das Leitungsmodul (223) an einer Oberfläche des ersten Gehäuses (210) bereitgestellt ist; und das erste Gehäuse (210) ein Metallblech (224), das konfiguriert ist, um das Leitungsmodul (223) abzudecken, aufweist.

11. AVN-Vorrichtung nach Anspruch 1, wobei:
das zweite Gehäuse (220) ein Metallmaterial, das eine höhere Wärmeleitfähigkeit als ein Metallmaterial aufweist, aus dem das erste Gehäuse (210) besteht, einschließt.

12. AVN-Vorrichtung nach Anspruch 1, wobei das erste Gehäuse (210) eine Vielzahl von Metallrippen (214), die aus einer Innenoberfläche des ersten Gehäuses (210) hervorstehen, einschließt,
wobei die Wärme, die von dem zweiten Gehäuse (220) übertragen wird, in einen Innenraum des ersten Gehäuses (210) abgeleitet und dann durch den Lüfter (214) an außerhalb des ersten Gehäuses (210) abgeleitet wird.

13. AVN-Vorrichtung nach Anspruch 1, ferner umfassend Anschlüsse, über die die erste Leiterplatte (211) und die zweite Leiterplatte (221) konfiguriert sind, um Elektrizität zu leiten, wenn das erste Gehäuse (210) und das zweite Gehäuse (220) miteinander gekoppelt sind.

## Revendications

1. Dispositif de navigation audio-vidéo (AVN) comprenant :
un premier boîtier (210) comportant une première carte de circuit imprimé (211) ;
un second boîtier (220) comportant une seconde carte de circuit imprimé (221), et conçu pour être accouplé de manière amovible au premier boîtier (210) ;
un module de conduction (223) situé entre le premier boîtier (210) et le second boîtier (220) lorsque le second boîtier (220) est accouplé au premier boîtier (210),
**caractérisé en ce que** le module de conduction (223) est conçu pour être comprimé et ainsi être en contact de surface à la fois avec le premier boîtier (210) et le second boîtier (220) en même temps lorsque le second boîtier (220) est accouplé au premier boîtier (210) ; et
le dispositif AVN comprend en outre un ventilateur de dissipation thermique (214) situé au niveau d'une surface du premier boîtier (210) pour évacuer de la chaleur générée dans le premier boîtier (210) à l'extérieur du premier boîtier (210).

2. Dispositif AVN selon la revendication 1, dans lequel le module de conduction (223) comporte :
une feuille adhésive (2231) dont une surface est attachée à une surface du premier boîtier (210) ou attachée à une surface du second boîtier (220) ;
une feuille thermoconductrice (2232) empilée sur l'autre surface de la feuille adhésive (2231) ; et
une feuille non adhésive (2233) empilée sur la feuille thermoconductrice (2232) et formée de manière à avoir une surface exposée non adhésive.

3. Dispositif AVN selon la revendication 1, dans lequel :
le module de conduction (223) a une épaisseur supérieure à une tolérance de montage entre le premier boîtier (210) et le second boîtier (220) ; et
le module de conduction (223) est conçu pour être déformé selon un degré de compression du premier boîtier (210) lorsqu'il est accouplé au second boîtier (220).

4. Dispositif AVN selon la revendication 1, comprenant en outre :
un premier composant électronique situé dans le premier boîtier (210) et connecté à la première carte de circuit imprimé (211) ; et
un second composant électronique situé dans le second boîtier (220), connecté à la seconde carte de circuit imprimé (221) et ayant un cycle de remplacement plus court que le premier composant électronique monté dans le premier boîtier (210).

5. Dispositif AVN selon la revendication 4, dans lequel :
le premier composant électronique est un composant fixe qui comporte au moins l'un parmi un composant de verrouillage de véhicule, une radio et un élément audio ; et
le second composant électronique est un composant remplaçable qui comporte au moins l'un parmi une UCT, une mémoire et un dispositif de communication.

6. Dispositif AVN selon la revendication 1, dans lequel le premier boîtier (210) comporte :
une pluralité d'ailettes métalliques (215) faisant saillie à partir d'une surface intérieure du premier boîtier (210) faisant face ou étant opposée à une surface extérieure du premier boîtier (210) en contact avec le second boîtier (220).

7. Dispositif AVN selon la revendication 1, dans lequel le premier boîtier (210) comporte :
une partie d'accouplement (212) conçue pour former un espace de logement auquel le second boîtier (220) est accouplé.

8. Dispositif AVN selon la revendication 7, dans lequel le second boîtier (220) comporte :
une surface d'accouplement (222) conçue pour entrer en contact avec la partie d'accouplement (212) ; et
une surface exposée (225) conçue pour être exposée à l'extérieur.

9. Dispositif AVN selon la revendication 8, dans lequel :
le module de conduction (223) est situé au niveau de la surface d'accouplement (222) du second boîtier (220).

10. Dispositif AVN selon la revendication 1, dans lequel le module de conduction (223) est situé au niveau d'une surface du premier boîtier (210) ; et le premier boîtier (210) comprend une feuille métallique (224) conçue pour recouvrir le module de conduction (223).

11. Dispositif AVN selon la revendication 1, dans lequel :
le second boîtier (220) comporte un matériau métallique qui a une conductivité thermique plus élevée qu'un matériau métallique constituant le premier boîtier (210).

12. Dispositif AVN selon la revendication 1, dans lequel le premier boîtier (210) comporte une pluralité d'ailettes métalliques (214) faisant saillie à partir d'une surface intérieure du premier boîtier (210),
dans lequel de la chaleur transférée du second boîtier (220) est dissipée dans un espace intérieur du premier boîtier (210), puis dissipée à l'extérieur du premier boîtier (210) par le biais du ventilateur (214).

13. Dispositif AVN selon la revendication 1, comprenant en outre des bornes par le biais desquelles la première carte de circuit imprimé (211) et la seconde carte de circuit imprimé (221) sont configurées pour conduire de l'électricité lorsque le premier boîtier (210) et le second boîtier (220) sont accouplés l'un à l'autre.
